# EUROPEAN PATENT APPLICATION

(11) **EP 0 702 455 A2**
(43) Date of publication of application: **20.03.1996**
(21) Application number: 95306342.7
(22) Date of filing: 11.09.1995
(51) Int. Cl.: H03K 17/0812

(54) **Overheat protection apparatus for self-turn-off device**

(30) Priority: 16.09.1994 JP 221181/94
(71) Applicant: FUJI ELECTRIC CO. LTD., Kawasaki 210 (JP)
(72) Inventor: Kiuchi, Shin, Kawasaki-ku, Kawasaki 210 (JP)
(74) Representative: Topley, Paul

(57) **Abstract**

To provide an overheating protection apparatus for a self-turn-off device having, the structure thereof is simplified without sacrificing its overheating detection capability.

An overheating protection apparatus (10) is provided for a self-turn-off device (1), that receives a driving voltage (V_{GS}) from a driver circuit (9) and controls a main circuit current (I_{D}). The overheating protection apparatus (10) consists of a series voltage divider circuit connecting a high-side element (11) and a low-side element (12), the impedances thereof showing different temperature dependence from one another. The high-side element (11) preferably comprises a semiconductor resistor further comprising, e.g. a P⁻ diffusion layer, and the low-side element (12) comprises a semiconductor resistor further comprising, e.g. a P⁺ poly-silicon layer.

## Description

The present invention relates to an overheating protection apparatus that detects an overcurrent flowing through a main circuit by the overheating of a voltage-driven type self-turn-off device, and prevents the self-turn-off device from being damaged by the overheating caused the overcurrent.

The expression 'self-turn-off device' is here used to indicate a device wherein a main current flowing between main terminals of the device is controlled by a variable voltage applied to a control terminal of the device. A transistor is only one example of such a device.

Figure 7 is a diagram showing an equivalent circuit of a first conventional overheating protection apparatus provided for a self-turn-off device. Referring now to Figure 7, a power MOSFET 1 as a self-turn-off device receives a driving voltage V_{GS} from a driver circuit 9 and controls a main circuit current I_{D}. The power MOSFET 1 is provided with a thyristor 3 as an overheat sensor. The power MOSFET 1 and thyristor 3 are disposed, for example, on a common chip. A limiting resistor 4 is connected between the gate of the power MOSFET 1 and the driver circuit 9. The thyristor 3 and the limiting resistor 4 constitute an overheating protection apparatus 2A. When the main circuit current I_{D} increases to an overcurrent, overheating is caused in the power MOSFET 1 by its internal loss and the thyristor 3, by virtue of its temperature dependence, turns on to short-circuit the gate and source of the power MOSFET 1. The power MOSFET 1 with its gate and source short-circuited is turned off to interrupt the main circuit current I_{D} and protects itself from being further overheated. The current flowing through the thyristor 3 is limited by the limiting resistor 4.

Figure 8 is a diagram showing an equivalent circuit of a second conventional overheating protection apparatus provided for a self-turn-off device. Referring now to Figure 8, an overheating protection apparatus 2B comprises a series circuit connecting a constant current element 5 and diodes 6 as an overheat sensor, the forward voltage V_{F} of the diodes 6 showing a negative temperature dependence. When the diodes 6 detect overheating of the power MOSFET 1, their forward voltage V_{F} drops. As the forward voltage V_{F} drops, the voltage applied to the gate terminal of MOSFET 1 is reduced, and the power MOSFET 1 limits the overcurrent to protect itself from being further overheated.

Figure 9 is a diagram showing an equivalent circuit of a third conventional overheating protection apparatus provided for a self-turn-off device. Referring now to Figure 9, an overheating protection apparatus 2C comprises a series circuit connecting a limiting resistor 4 and a PTC thermistor 7 as an overheat sensor, the resistance of the PTC thermistor showing a positive temperature dependence. When the PTC thermistor 7 detects overheating of the power MOSFET 1, its resistance sharply increases, and a comparator 7A compares the voltage at the midpoint of a voltage divider constricted by the thermistor 7 and a resistor 4 with a reference voltage from a reference voltage supply 7B, and inverts its output. The inverted output is fed to the gate of the power MOSFET 1, and the power MOSFET 1 limits the overcurrent of the main circuit to protect itself from being further overheated.

The first conventional overheating protection apparatus, shown in Figure 7, provided for the self-turn-off device, requires an additional turn-on circuit 8, consisting of a capacitor 8A and a resistor 8B connected in parallel as shown in Figure 10, for automatically recovering the thyristor 3 to its normal non-conducting state. The additional circuit parts cause increased installation space and cost of the overheating protection apparatus.

In the second conventional overheating protection apparatus of Figure 8, provided for the self-turn-off device, it is necessary to connect many diodes in series in order to raise the forward voltage V_{F} sufficiently to provide the driving voltage of the power MOSFET 1. This large number of diodes requires increased installation space, and increases the cost of the overheating protection apparatus.

The third conventional overheating protection apparatus of Figure 9 uses a PTC thermistor 7, whose resistance shows a sharp temperature dependence, for increasing the overheating detection accuracy. Since the PTC thermistor 7 requires additional parts such as the comparator 7A, an inverter 7C, etc., an increase in the installation space needed and in the cost of the overheating protection apparatus is caused.

In view of the foregoing, it is an object of the present invention to provide an overheating protection apparatus for a self-turn-off device, whose structure is simplified without sacrificing its overheating detection capability.

According to an aspect of the present invention, there is provided an overheating protection apparatus for detecting overheating of a self-turn-off device, which reduces a driving voltage and feeds the reduced driving voltage to a control terminal of the self-turn-off device for controlling a current of a main circuit in response to the driving voltage received at a control terminal thereof, wherein the overheating protection apparatus comprises a series voltage divider circuit further comprising a high-side element and a low-side element, the temperature dependence of the impedance thereof being different from one another, with the control terminal being connected to a midpoint between the high-side and low-side elements of the voltage divider.

It is preferable to use semiconductor resistors for the high-side element and the low-side element, the temperature dependence of the impedance of these semiconductor resistors being different from one another. For example, a semiconductor resistor including a P⁻ diffusion layer may be used for the high-side element and a semiconductor resistor further comprising a P⁺ poly-silicon layer may be used for the low-side element.

In an alternative arrangement, thermistors, whose temperature dependencies are different from one another, can be used for the high-side element and the low-side element.

It is also possible to use a voltage dividing resistor for the high-side element, and a constant current element may be used for the low-side element.

In a further alternative arrangement, a depletion type n-channel MOSFET may be used for the high-side element, and an enhancement type n-channel MOSFET for the low-side element, with the n-channel MOSFETs constituting a level shift circuit.

In yet another alternative, the high-side element may be a voltage dividing resistor, and a diode may be used for the low-side element.

The overheating protection apparatus of the invention is constructed as a series voltage divider circuit connecting a high-side element and a low-side element, the impedance (resistance values) of the high-side and low-side elements showing different temperature dependencies from one another. The elements of the series voltage divider circuit are mounted so as to be at the same temperature as each other, and at the same temperature as the self-turn-off device.

By setting the resistance ratio R₁₅₀/R₂₅, i.e. the ratio of the resistance value R₁₅₀ at a designated overheat detection temperature T₁₅₀ of 150°C to the resistance value R₂₅ at 25°C, to be larger for the high-side element than for the low-side element, the voltage dividing ratio of the divider circuit is expanded as the temperature rises, because the resistance of the high-side element increases more rapidly than the resistance of the low-side element for the same temperature rise. The effect of this is to reduce the voltage level at the midpoint of the series voltage divider circuit as the temperature rises. The resistance values are so selected that at the designated overheat detection temperature the driving voltage fed to the control terminal of the self-turn-off device is reduced to the point where the device becomes non-conducting or substantially non-conducting. The self-turn-off device interrupts or limits the overcurrent occurring in the main circuit in response to the reduced driving voltage. As a result, the self-turn-off device is protected from being further overheated and damaged by the overcurrent without using any other additional circuits.

A reduced driving voltage may also be obtained by using a semiconductor resistor having a P⁻ diffusion layer for the high-side element, and a semiconductor resistor having a P⁺ poly-silicon layer for the low-side element, wherein the ratio R₁₅₀/R₂₅ of the high-side element is twice as large as that of the low-side element.

A reduced driving voltage can also be obtained by using thermistors, whose temperature dependencies are different from one another. Specifically, this can be achieved by using a PTC thermistor showing a steep positive variation of resistance with temperature for the high-side element, and either an NTC thermistor showing a negative variation of resistance with temperature or a PTC thermistor showing small positive variation of resistance with temperature for the low-side element. The self-turn-off device interrupts or limits the overcurrent caused in the main circuit in response to the reduced driving voltage. As a result, the self-turn-off device is protected from being further overheated and damaged by the overcurrent.

A reduced driving voltage can also be obtained by using a voltage dividing resistor as the high-side element, and a constant current element, specifically a constant current diode showing positive variation of resistance with temperature for a current in the low current range, as the low-side element. The self-turn-off device interrupts or limits the overcurrent caused in the main circuit in response to the reduced driving voltage. As a result, the self-turn-off device is protected from being further overheated and damaged by the overcurrent.

A reduced driving voltage can also be obtained also by using a depletion type N-channel MOSFET and an enhancement type N-channel MOSFET, whose on-resistances show different temperature dependencies from one another, for the high-side element and a constant current element for the low-side element, respectively, and by connecting the MOSFETs in a level shift circuit. The self-turn-off device interrupts or limits the overcurrent caused in the main circuit in response to the reduced driving voltage. As a result, the self-turn-off device is protected from being further overheated and damaged by the overcurrent.

A reduced driving voltage may alternatively be obtained by using a voltage dividing resistor for the high-side element, and a diode whose on-resistance shows a negative temperature dependence, as an overheat sensor for the low-side element. The self-turn-off device interrupts or limits the overcurrent caused in the main circuit in response to the reduced driving voltage. As a result, the self-turn-off device is protected from being further overheated and damaged by the overcurrent.

Hereinafter, the present invention will be explained with reference to the accompanying drawings which illustrate preferred embodiments of the invention. Throughout the drawings, parts common with those of the conventional overheating protecting apparatus are designated by the same reference numerals and their explanations are omitted. In the Figures:
Figure 1 is a diagram showing an equivalent circuit of a first embodiment of an overheating protection apparatus according to the present invention for a self-turn-off device;
Figure 2 is a graph showing the temperature dependence of the resistance ratios of the overheating protection apparatus of Figure 1;
Figure 3 is a diagram showing an equivalent circuit of a second embodiment of an overheating protection apparatus according to the present invention for a self-turn-off device;
Figure 4 is a diagram showing an equivalent circuit of a third embodiment of an overheating protection apparatus according to the present invention for a self-turn-off device;
Figure 5 is a diagram showing an equivalent circuit of a fourth embodiment of an overheating protection apparatus according to the present invention for a self-turn-off device;
Figure 6 is a diagram showing an equivalent circuit of a fifth embodiment of an overheating protection apparatus according to the present invention for a self-turn-off device;
Figure 7 is a diagram showing an equivalent circuit of a first conventional overheating protection apparatus for a self-turn-off device;
Figure 8 is a diagram showing an equivalent circuit of a second conventional overheating protection apparatus for a self-turn-off device;
Figure 9 is a diagram showing an equivalent circuit of a third conventional overheating protection apparatus for a self-turn-off device, and;
Figure 10 is a diagram showing an equivalent circuit of the first conventional overheating protection apparatus having a reconnection circuit.

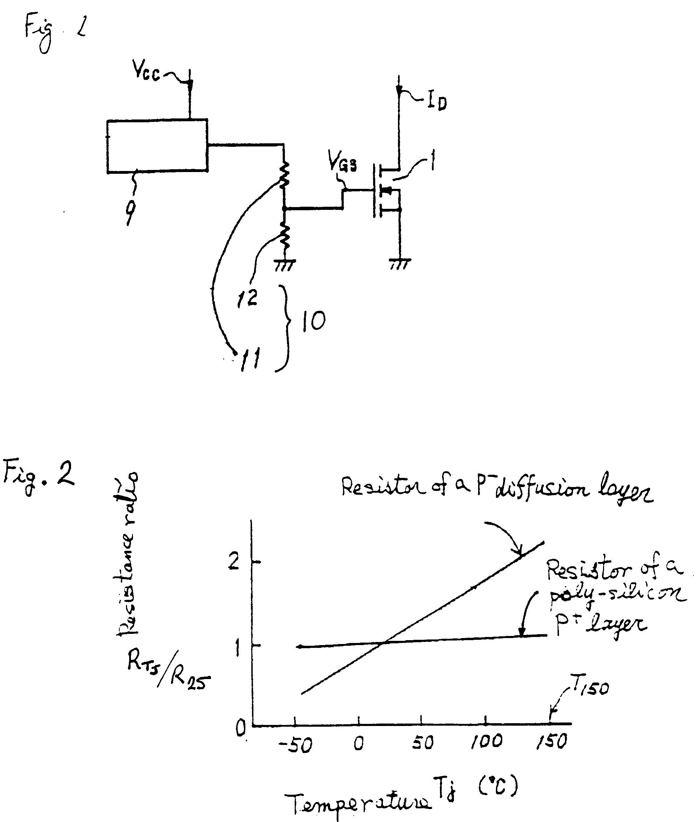

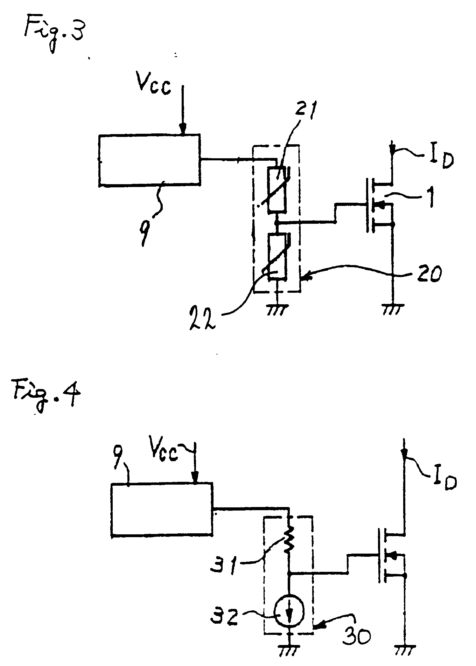

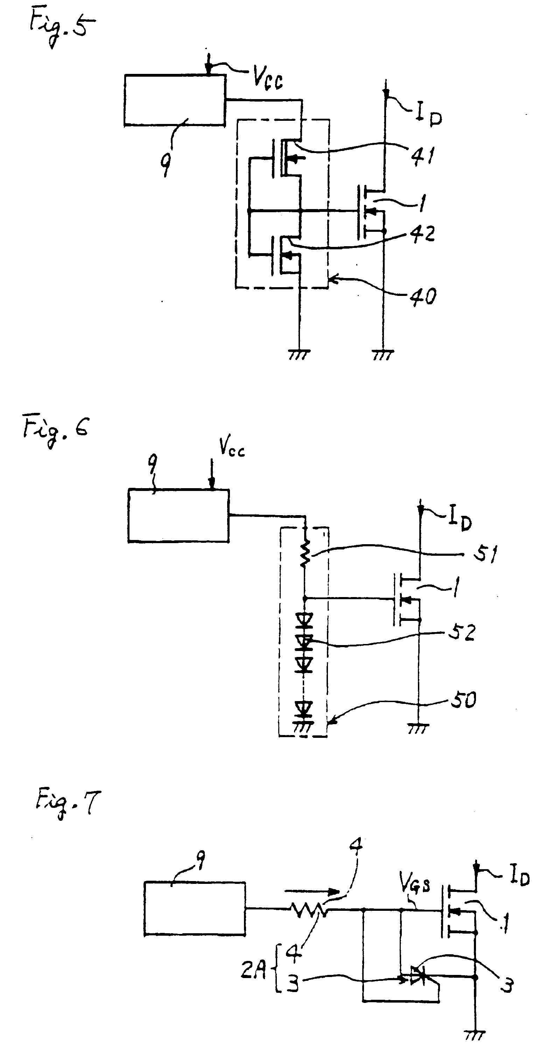

Referring now to the drawings, Figure 1 is a diagram showing an equivalent circuit of a first embodiment of an overheating protection apparatus according to the present invention for a self-turn-off device. In Figure 1, a self-turn-off device 1 (N-channel MOSFET 1 in Figure 1) receives a driving voltage V_{GS} from a driver circuit 9 and controls a main circuit current I_{D}. An overheating protection apparatus 10 is provided for the self-turn-off device 1. The overheating protection apparatus 10 consists of a series voltage divider circuit formed by a high-side element 11 connected in series with a low-side element 12. The high-side element 11 is a semiconductor resistor having a P⁻ diffusion layer, and the low-side element 12 is a semiconductor resistor having a P⁺ poly-silicon layer. The series voltage divider circuit 10 receives at its high-side an output voltage from a driver circuit 9, and outputs a divided driving voltage V_{GS} from a point between the series-connected high- and low-side elements 11 and 12 to the gate of the self-turn-off device 1. The ratio of the voltage V_{GS} to the output voltage of driver circuit 9 depends on the relative values of the resistances of the elements 11 and 12. The self-turn-off device 1 switches on and off in response to the divided driving voltage V_{GS} to control the main circuit current I_{D} flowing between the drain and the source terminals of the device 1.

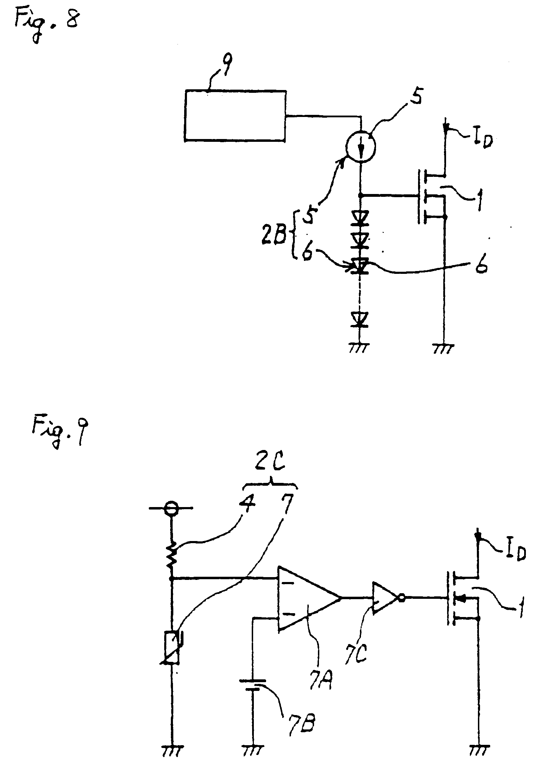

Figure 2 is a graph showing the variation of the resistance ratio with temperature of the overheating protection apparatus. Specifically, the graph shows resistance at each temperature Tⱼ in terms of the resistance R₂₅ at 25°C. Though the resistance ratio of the P⁻ diffusion layer and the resistance ratio of P⁺ poly-silicon layer both increase with temperature, the P⁻ diffusion layer shows a larger variation of the resistance ratio with temperature than does the P⁺ poly-silicon layer. At the overheat detection temperature of 150°C (T₁₅₀), the P⁻ diffusion layer shows a resistance ratio twice as large as that of the P⁺ poly-silicon layer. Therefore, the voltage at the midpoint of the series voltage divider circuit shows a negative temperature dependence that facilitates reducing the shared voltage of the low-side element 12 in comparison with the shared voltage of the high-side element 11 at the overheat detection temperature of 150°C. By using the series voltage divider circuit as an overheat sensor of the overheating protection apparatus, the overheating protection apparatus 10 facilitates reducing the driving voltage fed to the gate of the self-turn-off device 1 when the overheating protection apparatus 10 has detected overheating of the self-turn-off device 1. The reduced driving voltage turns off the self-turn-off device 1 to interrupt or limit the overcurrent. Thus, the overheating protection apparatus 10 prevents the self-turn-off device 1 from being further overheated and damaged thermally.

Since the overheating protection apparatus 10 can be constructed without using additional parts, the structure of the overheating protection apparatus 10 is simplified. Since the semiconductor resistor comprising of a P⁻ diffusion layer and the semiconductor resistor comprising of a P⁺ poly-silicon layer can be built economically on the same chip with the self-turn-off device 1 during the semiconductor manufacturing process, the overheating protection apparatus 10 facilitates detecting overheating quickly and accurately, and protecting the self-turn-off device 1 from being overheated and damaged by an overcurrent. The overheating protection apparatus 10 of the invention does not lead to an increase in size of the self-turn-off device 1, and facilitates the economic provision of self-turn-off devices having overheating detection. By using the self-turn-off device provided with the overheating protection apparatus as an overcurrent protection switch for switching on and off of a load current, a short-circuit current or an overcurrent caused in the electrical parts and components of the load circuit can be interrupted without using a fuse, and the electrical parts and components can be protected from damage.

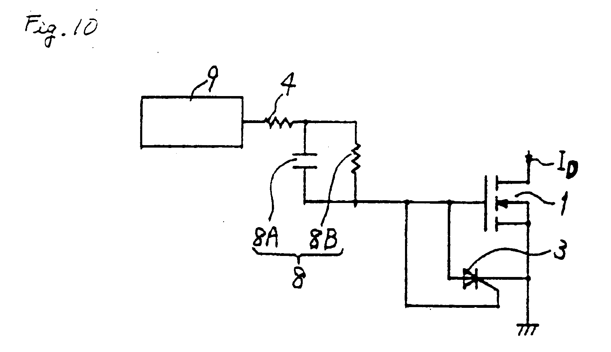

Figure 3 is a diagram showing an equivalent circuit of a second embodiment of an overheating protection apparatus according to the present invention. Referring now to Figure 3, an overheating protection apparatus 20 comprises a series voltage divider circuit connecting a high-side element 21 and a low-side element 22. The high-side element 21 is a first thermistor, and the low-side element 22 is a second thermistor showing different temperature dependence from that of the first thermistor 21. For example, by using a PTC thermistor showing a steep positive temperature dependence as the high-side element 21 and an NTC thermistor showing a negative temperature dependence, or a PTC thermistor showing small positive temperature dependence, as the low-side element 22, the driving voltage fed to the gate of the self-turn-off device connected to the dividing terminal (middle connection point) of the series voltage divider circuit is progressively reduced as the temperature rises, assuming a constant output voltage from the driver circuit 9. The driving voltage is eventually reduced to the point where the self-turn-off device 1 turns off to interrupt the overcurrent. Thus, the self-turn-off device 1 is prevented from being further overheated. The second embodiment shows similar effects as those of the first embodiment.

Figure 4 is a diagram showing an equivalent circuit of a third embodiment of an overheating protection apparatus according to the present invention for a self-turn-off device. Referring now to Figure 4, an overheating protection apparatus 30 comprises a series voltage divider circuit connecting a high-side element 31 and a low-side element 32. The high-side element 31 is a voltage dividing resistor, and the low-side element 32 is a constant current element. By using a constant current diode whose current shows positive temperature dependence (i.e.its resistance shows negative temperature dependence) in a small current range as the constant current element in an overheat sensor, the voltage across the voltage dividing resistor can be increased and the voltage across constant current element can be reduced as the temperature rises. The reduced shared voltage of the constant current element is fed to the gate of the self-turn-off device to limit an overcurrent flow and to prevent the self-turn-off device from being further overheated. The third embodiment thus shows similar effects to those of the first and second embodiments.

Figure 5 is a diagram showing an equivalent circuit of a fourth embodiment of an overheating protection apparatus according to the present invention for a self-turn-off device. Referring now to Figure 5, an overheating protection apparatus 40 consists of a level shift circuit connecting a high-side element 41 and a low-side element 42 in series. The high-side element 41 is a depletion type N-channel MOSFET and the low-side element 42 is an enhancement type N-channel MOSFET connected in series with one another on the side of the main circuit. By using two MOSFETs, whose on-resistances show opposite temperature dependencies from one another as an overheat sensor, a reduced proportion of the driving voltage output from the driver circuit 9 is fed to the gate of the self-turn-off device as the temperature rises to limit an overcurrent and to prevent the self-turn-off device from being further overheated. The fourth embodiment shows similar effects to those of the other embodiments described above.

Figure 6 is a diagram showing an equivalent circuit of a fifth embodiment of an overheating protection apparatus according to the present invention for a self-turn-off device. Referring now to Figure 6, an overheating protection apparatus 50 is consists of a series voltage divider circuit connecting a high-side element 51 and a low-side element 52. The high-side element 51 is a voltage dividing resistor, and the low-side element 52 is a diode. By using a diode whose forward voltage shows negative temperature dependence as an overheat sensor, as the temperature rises then the driving voltage fed to the gate of the self-turn-off device is reduced to limit any overcurrent flow and to prevent the self-turn-off device from being further overheated. The fifth embodiment shows similar effects to those of the other embodiments described above.

As has been explained so far, the overheating protection apparatus of the invention is constructed as a series voltage divider circuit connecting a high-side element and a low-side element, the impedance of the high-side and low-side elements having different temperature dependencies from one another. By using the series voltage dividing circuit as an overheat sensor, overheating of the self-turn-off device can be detected quickly and accurately, and a reduced driving voltage is then fed to the self-turn-off device to interrupt or limit an overcurrent. As a result, the self-turn-off device is protected from being further overheated and damaged by the overcurrent. The overheating protection apparatus of the invention does not involve increasing the size of the self-turn-off device, and facilitates providing self-turn-off devices having overheating detection function economically. By using the self-turn-off device provided with the overheating protection apparatus as an overcurrent protection switch for switching a load current on and off, a short-circuit current or an overcurrent caused in the electrical parts and components of the load circuit can be interrupted without using a fuse, and the electrical parts and components can be prevented from being damaged.

It will be appreciated that the overheating protection apparatus of the invention may also be applied to a self-turn-off device which ceases to conduct when the voltage at the control terminal of the self-turn-off device rises above a predetermined value, by arranging for the impedance of the low-side element to rise with temperature at a greater rate than does the impedance of the high-side element.

## Claims

1. An overheating protection apparatus for detecting overheating of a self-turn-off device, for reducing a driving voltage, and for feeding the reduced driving voltage to a control terminal of the self-turn-off device wherein a current of a main circuit is controlled in response to the driving voltage received at a control terminal thereof, the overheating protection apparatus comprising:
a series voltage divider circuit further comprising a high-side element and a low-side element, the temperature dependencies of the impedance of the high-side element and the low-side element being different from one another.

2. The overheating protection apparatus according to claim 1, wherein the high-side element comprises a semiconductor resistor, and the low-side element comprises a semiconductor resistor.

3. The overheating protection apparatus according to claim 2, wherein the high-side element comprises a semiconductor resistor further comprising a P⁻ diffusion layer, and the low-side element comprises a semiconductor resistor further comprising a P⁺ poly-silicon layer.

4. The overheating protection apparatus according to claim 1, wherein the high-side element comprises a thermistor, and the low-side element comprises a thermistor, the temperature dependencies of the thermistors being different from one another.

5. The overheating protection apparatus according to claim 1, wherein the high-side element comprises a voltage dividing resistor, and the low-side element comprises a constant current element.

6. The overheating protection apparatus according to claim 1, wherein the high-side element comprises a depletion type n-channel MOSFET, and the low-side element comprises an enhancement type n-channel MOSFET, the n-channel MOSFETs constituting a level shift circuit.

7. The overheating protection apparatus according to claim 1, wherein the high-side element comprises a voltage dividing resistor, and the low-side element comprises a diode.

8. The overheating protection apparatus according to claim 1, wherein the impedance of the high-side element rises with temperature at a greater rate than does the impedance of the low-side element, and wherein the self-turn-off device ceases to conduct when the voltage at the control terminal of the self-turn-off device falls below a predetermined value.

9. The overheating protection apparatus according to claim 1, wherein the impedance of the low-side element rises with temperature at a greater rate than does the impedance of the high-side element, and wherein the self-turn-off device ceases to conduct when the voltage at the control terminal of the self-turn-off device rises above a predetermined value.
